# EUROPEAN PATENT APPLICATION

(11) **EP 4 794 471 A1**
(43) Date of publication of application: **19.08.2026**
(21) Application number: 25191364.6
(22) Date of filing: 23.07.2025
(51) Int. Cl.: H10D 12/01, H10D 12/00, H10D 62/10, H10D 62/13, H10D 62/17, H10D 64/00

(54) **SUPER-JUNCTION IGBT DEVICE WITH SEPARATION GATE STRUCTURES AND PREPARATION METHOD THEREOF**

(30) Priority: 12.02.2025 CN 202510154774
(71) Applicant: Chongqing Alpha and Omega Semiconductor Limited, Chongqing 400700 (CN)
(72) Inventor: ZHANG, Jiaxin, Chongqing, 400700 (CN); HU, Wei, Chongqing, 400700 (CN); TANG, Yu, Chongqing, 400700 (CN)
(74) Representative: Metida

(57) **Abstract**

A super-junction IGBT device with separation gate structures and a preparation method thereof are provided. The super-junction IGBT device includes an epitaxial layer (200). P-pillars (220) and N-pillars (210) are periodically formed in the epitaxial layer (200). A P-base region (230) is formed on an upper portion of the epitaxial layer (200). The separation gate structures (350) are disposed above the N-pillars. An N-type region (240) is formed between the separation gate structures (350) and formed on the P-base region (230). A first P+ contact layer (250) is formed on the N-type region (240). The device comprises and active switching region comprising trench gates (330), an N+ emitter region (260), an active body region (230) adjacent the gates (330) and a P+ type body contact region (270), and furthermore a P+ collector layer (110) disposed on a lower end of the epitaxial layer (200) and a back metal (500) disposed at a lower end of the P+ collector layer (110). An emitter metal (400) is disposed at upper ends of the emitter region (260), the body contact region (270), the separation gate structures and an upper end of the first P + layer (250).

## Description

### TECHNICAL FIELD

The present disclosure relates to a field of semiconductor devices, and in particular relates to a super-junction insulated gate bipolar transistor (IGBT) device with separation gate structures and a preparation method thereof.

### BACKGROUND

Compared to a conventional silicon-based insulated gate bipolar transistor (IGBT) device, a super-junction IGBT (SJ-IGBT) device introduces alternately disposed N and P-pillars within a drift region thereof. It leverages the lateral depletion between the N and P-pillars to optimize an electric field distribution thereof, which enables the SJ-IGBT device to have a higher breakdown voltage and a higher current density under the same drift region length as that of the conventional IGBT device. When the SJ-IGBT device is turned-off, the depletion of a PN junction between the N and P-pillars accelerates the extraction of carriers, thereby reducing turn-off loss. However, when the SJ-IGBT device is in an on state, holes easily flow from the P-pillars through P-well regions to an emitter, resulting in insufficient hole storage, weakening a conductivity modulation effect, and leading to an increase in an on-state voltage drop.

### SUMMARY

In view of defects in the prior art, the present disclosure provides a super-junction insulated gate bipolar transistor (IGBT) device with separation gate structures and a preparation method thereof.

To solve problems in the prior art, the present disclosure provides the super-junction IGBT device. The super-junction IGBT device comprises an epitaxial layer, P-pillars, N-pillars, a P-base region, the separation gate structures, an N-base region, a first P + layer, a second P + layer, a back metal, and an emitter metal. The P-pillars and the N-pillars are periodically formed in the epitaxial layer by performing ion implantation. The P-base region is formed on an upper portion of the epitaxial layer by performing the ion implantation. The separation gate structures are disposed above the N-pillars. The N-base region is formed between the separation gate structures and formed on the P-base region by performing the ion implantation. The first P + layer is formed on the N-base region by performing the ion implantation. The second P + layer is disposed on a lower end of the epitaxial layer. The back metal is disposed at a lower end of the second P + layer. The emitter metal is disposed at upper ends of the separation gate structures and an upper end of the first P + layer.

The P-pillars and the N-pillars are periodically disposed below the P-base region along a first direction. An upper end of each of the P-pillars and an upper end of each of the N-pillars are connected to the P-base region. A doping concentration of the P-base region is greater than a doping concentration of the P-pillars.

Furthermore, each of the separation gate structures comprises two trenches, separation gates, N + regions and P + regions. The separation gates are respectively disposed in the two trenches. The N + regions and the P + regions are periodically disposed between the two trenches along a second direction. The second direction is perpendicular to the first direction.

Furthermore, each of the separation gates comprises a gate oxide layer covering a trench wall of a corresponding one of the trenches, a gate electrode disposed at a lower portion of the corresponding one of the trenches, a cathode disposed at an upper portion of the corresponding one of the trenches, and a gate dielectric layer disposed between the gate electrode and the cathode.

Furthermore, a depth of each of the P + regions is the same as a depth of the first P + layer.

Furthermore, a lower end surface of each of the N+ regions is lower than an upper end surface of each gate electrode.

Furthermore, an upper end of the first P + layer, an upper end of each of the P + regions, an upper end of each of the N+ regions, and an upper end of each cathode are directly connected to the emitter metal.

The present disclosure further provides the preparation method of a super-junction IGBT device with separation gate structures. The preparation method comprises steps S100-S600.

The step S100 comprises providing an N-type doped silicon substrate.

The step S200 comprises epitaxially growing N-type doped silicon on the N-type doped silicon substrate to form an epitaxial layer, and forming P-pillars disposed along a first direction by performing ion implantation on the epitaxial layer. Portions of the epitaxial layer disposed between the P-pillars are defined as N-pillars.

The step S300 comprises performing the ion implantation on an upper portion of the epitaxial layer to form a P-base region, and forming two trenches above each of the N-pillars. The two trenches extend downward to penetrate through the P-base region and extend into each of the N-pillars.

The step S400 comprises forming N + regions and P + regions periodically disposed in a second direction at an upper end of the P-base region and between the two trenches disposed above each of the N-pillars by performing the ion implantation, and forming a N-base region and a first P + layer at the upper end of the P-base region and between each two adjacent N-pillars by performing the ion implantation.

The step S500 comprises forming separation gates respectively in the trenches.

The step S600 comprises forming an emitter metal at an upper end of the epitaxial layer, forming a second P + layer by performing the ion implantation on the N-type doped silicon substrate, and forming a back metal at a lower end of the second P + layer.

Furthermore, in the step S200, the epitaxial layer is formed by epitaxially growing a plurality of N-type doped silicon layers, and the ion implantation is performed at positions of each of the N-type doped silicon layers to form P-pillar segments.

Furthermore, the step S400 comprises steps S410-S420.

The step S410 comprises forming the N-base region at the upper end of the P-base region and between each two adjacent N-pillars by performing an N-type ion implantation, forming the N + regions disposed in the second direction at the upper end of the P-base region and between the two trenches disposed above each of the N-pillars, and exposing upper surfaces of the N + regions.

The step S420 comprises forming the first P + layer on the upper portion of the N-base region by performing a P-type ion implantation, forming the P + regions on portions of the upper portion of the P-base region between adjacent N + regions, and exposing an upper surface of the first P + layer and upper surfaces of the P + region.

Furthermore, the step S500 comprises steps S510-S530.

The step S510 comprises etching first polysilicon disposed in each of the trenches, and retaining a portion of the first polysilicon disposed at a lower portion of each of the trenches to form a gate electrode.

The step S520 comprises depositing an oxide layer on an upper end of each gate electrode to form a gate dielectric layer.

The step S530 comprises growing second polysilicon on an upper portion of each of the trenches, and etching to form a cathode.

In the present disclosure, by defining the two trenches above each of the N-pillars, by providing separation gates of an upper and lower structure in the trenches, and by sequentially providing the P-base region, the N-base region, and the P+ layer between two adjacent trenches directly above the P-pillars, outflow of holes is blocked when the super-junction IGBT device is turned on, which enhances a conductivity modulation effect, and reduces the on-state voltage drop. When the super-junction IGBT device is turned off, an additional hole extraction channel is formed to accelerate the current shutoff and further reduce the shutoff loss. Further, the Miller capacitance and the switching loss are reduced, a dielectric layer and tungsten plugs are omitted, and a process window increases, so that the super-junction IGBT device is allowed to have a smaller size than other SJ-IGBT devices in the prior art.

### BRIEF DESCRIPTION OF DRAWINGS

FIG. 1 is a schematic diagram of a super-junction IGBT device with separation gate structures according to one embodiment of the present disclosure.
FIG. 2 is a schematic diagram of the super-junction IGBT device shown in FIG. 1 where an emitter metal is removed.
FIG. 3 is a cross-sectional schematic diagram of the super-junction IGBT device taken along the line A-A shown in FIG. 2.
FIG. 4 is a cross-sectional schematic diagram of the super-junction IGBT device taken along the line B-B shown in FIG. 2.
FIG. 5 is a cross-sectional schematic diagram of the super-junction IGBT device taken along the line C-C shown in FIG. 2.
FIG. 6 is a cross-sectional schematic diagram of the super-junction IGBT device taken along the line D-D shown in FIG. 2.
FIG. 7 is a flow chart of a preparation method of the super-junction IGBT device according to one embodiment of the present disclosure.
FIG. 8 is a cross-sectional schematic diagram of a structure with P-pillar segments obtained after the step S200.
FIG. 9 is a cross-sectional schematic diagram of a structure obtained after the step S300.
FIG. 10 is a cross-sectional schematic diagram of a structure obtained after the step S400.
FIG. 11 is a cross-sectional schematic diagram of the super-junction IGBT device obtained after the step S600.

### DETAILED DESCRIPTION

A conventional super-junction insulated gate bipolar transistor (SJ-IGBT) device introduces alternately disposed N and P-pillars, and the P-pillars are connected with a P-base region. It leverages the lateral depletion between the N and P-pillars to optimize an electric field distribution thereof, which enables the conventional SJ-IGBT device to have a higher breakdown voltage and a higher current density under the same drift region length as that of a conventional IGBT device. Since the depletion of a PN junction between the N and P-pillars accelerates an extraction of carriers, a turn-off speed is quick. However, P-pillar regions provide hole extraction channels directly connected to P-base region, which affects a conductivity modulation level of the conventional super-junction IGBT device under forward conduction, making the conventional SJ-IGBT device present a larger Vcesat. Further, the Miller capacitance of the conventional SJ-IGBT device is larger. Therefore, it is necessary to reduce the Vcesat and switching loss of the conventional SJ-IGBT device.

In the prior art, some SJ-IGBT devices are SJ-IGBT devices with floating P-pillars, and N-pillars and P-pillars thereof are alternately disposed, and the lateral depletion of N-pillars and P-pillars is utilized to improve the electric field distribution, but the P-pillars are no longer connected to the P-base region. Since the P-pillars no longer extract holes, the carriers increase and the Vcesat decreases. However, since the holes are only extracted from the P-base region, the extraction efficiency is reduced, resulting in a longer turn-off time and increased turn-off loss. Further, the SJ-IGBT devices have a large Miller capacitance and a large switching loss; and when developing to a smaller size, a process window thereof is smaller.

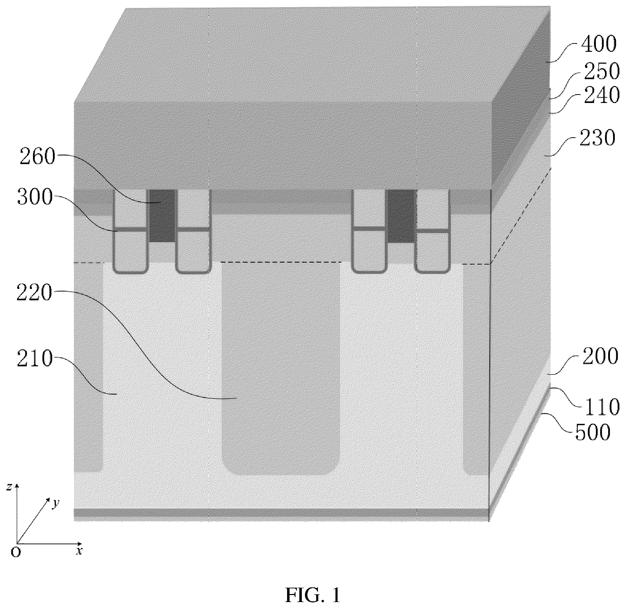

To solve problems in the prior art, the present disclosure provides a super-junction IGBT device with separation gate structures. FIG. 1 is a schematic diagram of a super-junction IGBT device with separation gate structures according to one embodiment of the present disclosure. As shown in FIG. 1, the super-junction IGBT device comprises an epitaxial layer 200, P-pillars 220, N-pillars 210, a P-base region 230, the separation gate structures, an N-base region 260, a first P + layer 250, a second P + layer, a back metal, and an emitter metal. The P-pillars 220 and the N-pillars 210 are 230 periodically formed in the epitaxial layer 200 by performing ion implantation. The P-base region 230 is formed on an upper portion of the epitaxial layer 200 by performing the ion implantation. The P-pillars 220 and the N-pillars 210 upper ends are periodically disposed below the P-base region 230 along a first direction the x direction shown in FIGS. 1-2. An upper end of each of the P-pillars 220 and an upper end of each of the N-pillars 210 are connected to the P-base region 230. A doping concentration of the P-base region 230 is greater than a doping concentration of the P-pillars 220.

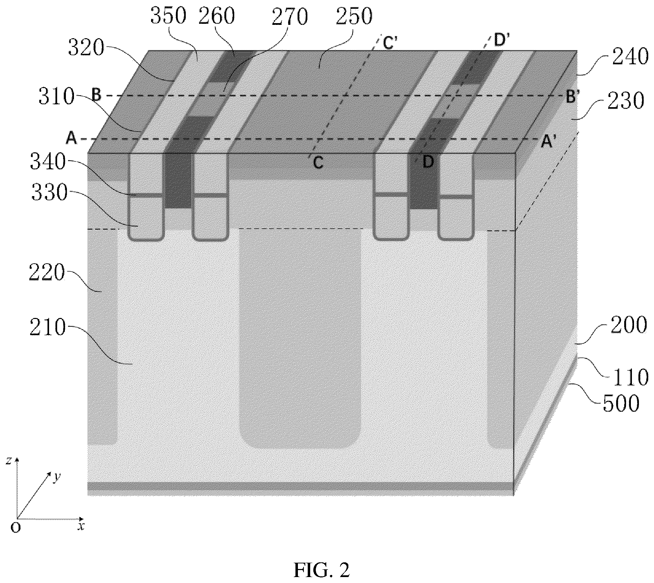

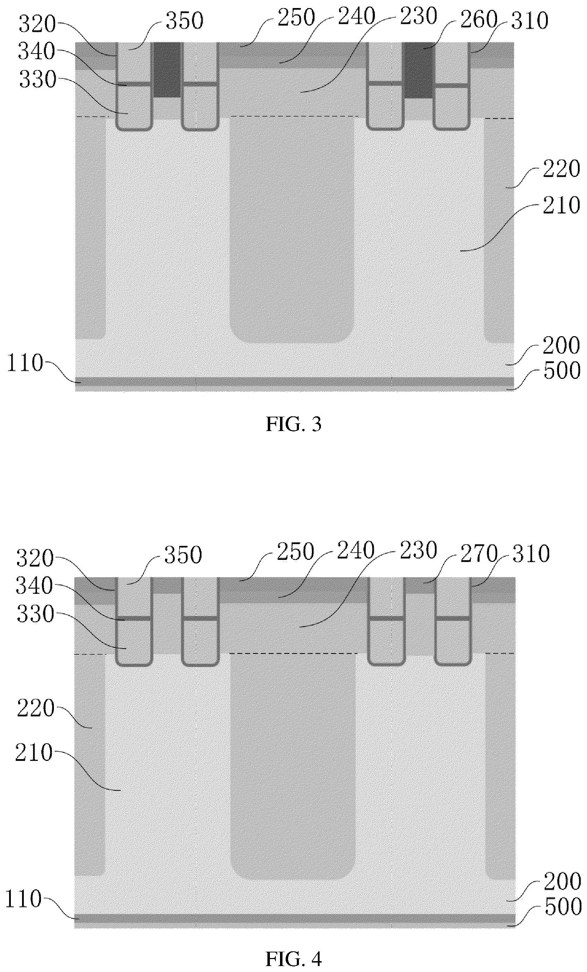

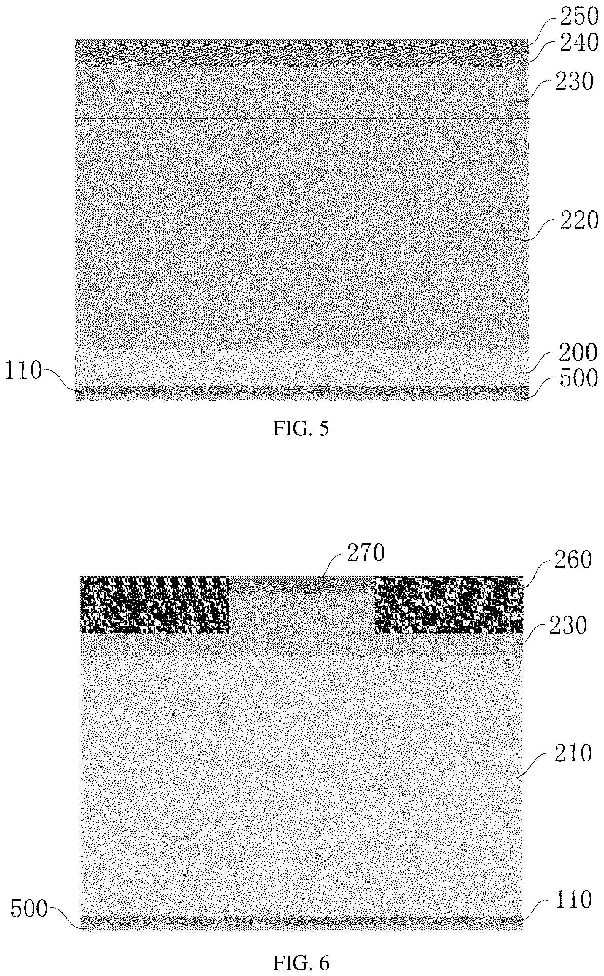

As shown in FIGS. 2-6, the separation gate structures are disposed above the N-pillars 210. Each of the separation gate structures comprises two trenches 310, separation gates 300, N + regions and P + regions 270. The separation gates 300 are respectively disposed in the two trenches 310. The N + regions and the P + regions 270 are periodically disposed between the two trenches 310 along a second direction the y direction shown in FIGS. 1-2. The second direction is perpendicular to the first direction. A lower end surface of each of the N+ regions is lower than an upper end surface of each gate electrode. A depth of each of the P + regions 270 is the same as a depth of the first P + layer 250. The two trenches 310 thereof extend downward to penetrate through the P-base region 230 and extend into each of the N-pillars 210. Each of the separation gate 300 comprises a gate oxide layer 320 covering a trench wall of a corresponding one of the trenches 310, a gate electrode 330 disposed at a lower portion of the corresponding one of the trenches 310, a cathode 350 disposed at an upper portion of the corresponding one of the trenches 310, and a gate dielectric layer 340 disposed between the gate electrode 330 and the cathode 350. Each gate electrode 330 and each cathode 350 are formed of polysilicon.

The N-base region 260 is formed between the separation gate structures and formed on the P-base region 230 by performing the ion implantation. The first P + layer 250 is formed on the N-base region 260 by performing the ion implantation. The second P + layer 110 is disposed on a lower end of the epitaxial layer 200. As shown in FIG. 1, the back metal 500 is disposed at a lower end of the second P + layer 110. The emitter metal is disposed at upper ends of the separation gate structures and an upper end of the first P + layer 250. An upper end of the first P + layer 250, an upper end of each of the P + regions 270, an upper end of each of the N+ regions, and an upper end of each cathode are directly connected to the emitter metal.

In the embodiment, the P-pillars 220 and the N-pillars 210 are alternately disposed to form SJ structures, and the trenches 310 are disposed above the N-pillars 210. Each of the separation gates 300 including an upper structure and a lower structure is disposed in a corresponding one of the trenches 310, where the lower structure is connected to the gate electrode thereof and the upper structure is connected to the emitter. There are the P-base region, the N+ regions 260 and the P+ regions 270 between the trenches 310, and the P-base region, the N-base region and the first P+ layer 250 are disposed directly above the P-pillars 220.. Thus, the super-junction IGBT device has following characteristics.

An on-state voltage drop and a turn-off loss of the super-junction IGBT device are low. When the super-junction IGBT device is turned on, the dense N-base region directly above the P-pillars 220 acts as hole barriers to block the outflow of holes, which enhances a conductivity modulation effect and reduces the on-state voltage drop Vcesat. When the super-junction IGBT device is turned off, since the upper portion of each of the separation gates 300 is connected to the emitter, as a collector voltage increases, positive channel metal oxide semiconductors formed by the P-base region, the N-base region, and the P+ regions above the P-pillars 220 are turned on, forming additional hole extraction channels, accelerating the current shutdown, and further reducing the turn-off loss.

The Miller capacitance of the super-junction IGBT device is low, reducing the switching loss. An area of the gate electrode 330 in each of the separation gates 300 is small, and the upper portion of each of the separation gates 300 is connected to the emitter, thereby converting a part of the gate-collector capacitance Cgc into the gate-emitter capacitance Cge, so the Miller capacitance Cgc is reduced, and the switching loss is reduced accordingly.

Since the upper end of the first P+ layer 250, the upper end of each of the P+ region s270, the upper end of each of the N+ regions 260 and the upper end of the cathode 350 are directly connected to the emitter metal 400, a dielectric layer and tungsten plugs are omitted.

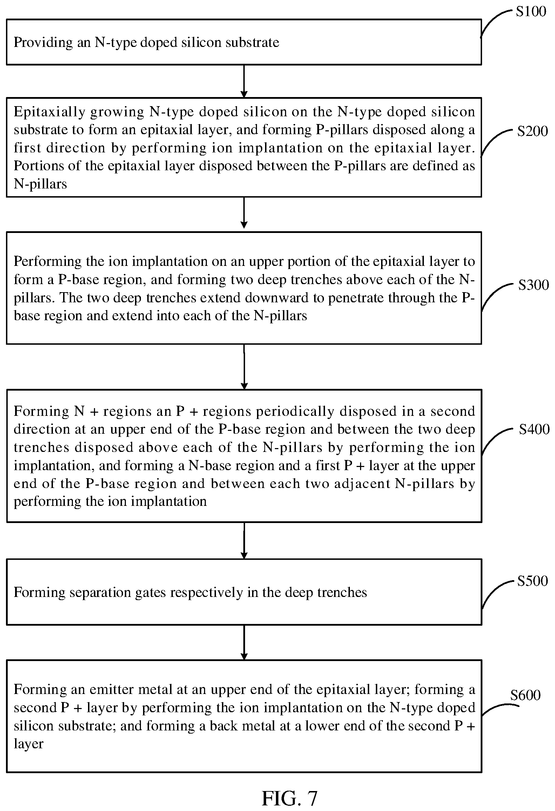

FIG. 7 is a flow chart of a preparation method of the super-junction IGBT device according to one embodiment of the present disclosure. As shown in FIG. 7, the present disclosure further provides the preparation method of the super-junction IGBT device with the separation gate structures. The preparation method comprises steps S 100-S600.

The step S100 comprises providing an N-type doped silicon substrate.

The step S200 comprises epitaxially growing N-type doped silicon on the N-type doped silicon substrate to form an epitaxial layer 200, and forming P-pillars disposed along a first direction by performing ion implantation on the epitaxial layer 200. Portions of the epitaxial layer 200 disposed between the P-pillars are defined as N-pillars 210. In the step S200, the epitaxial layer 200 is formed by epitaxially growing a plurality of N-type doped silicon layers, and the ion implantation is performed at positions of each of the N-type doped silicon layers to form P-pillar segments. Through multiple times of epitaxial growths and multiple times of ion implantations, the P-pillar segments 221 are connected to form the P-pillars 220.

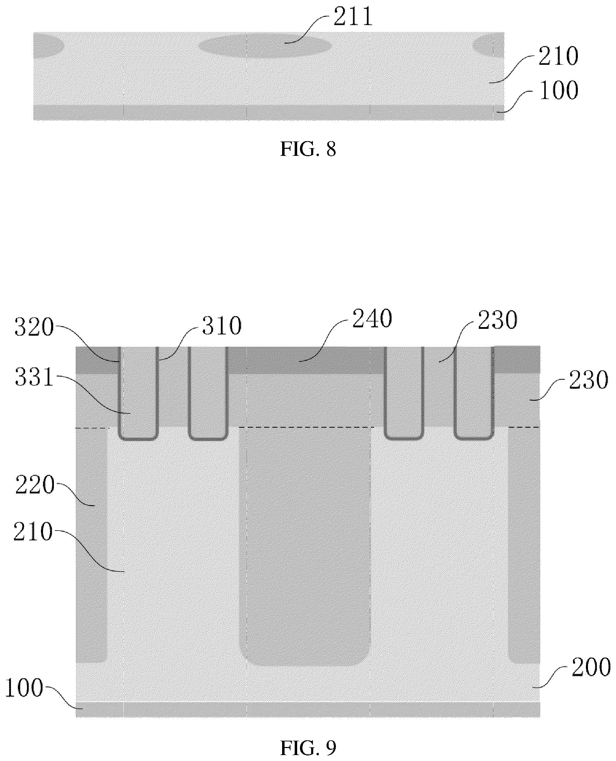

As shown in FIG. 9, the step S300 comprises performing the ion implantation on an upper portion of the epitaxial layer 200 to form a P-base region 230, and forming two trenches 310 above each of the N-pillars 210. The two trenches 310 extend downward to penetrate through the P-base region 230 and extend into each of the N-pillars 210. An oxide layer is deposited on a trench wall of each of the trenches 310 to form a gate oxide layer 320, and then each of the trenches 310 is filled with a first polysilicon 331.

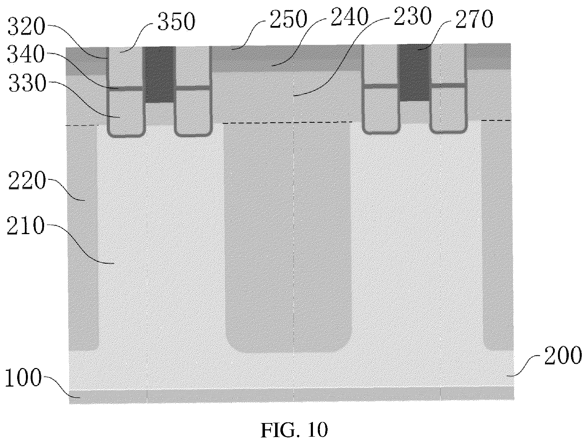

As shown in FIG. 10, the step S400 comprises forming N + regions and P + regions 270 periodically disposed in a second direction at an upper end of the P-base region 230 and between the two trenches 310 disposed above each of the N-pillars 210 by performing the ion implantation, and forming a N-base region 260 and a first P + layer 250 at the upper end of the P-base region 230 and between each two adjacent N-pillars 210 by performing the ion implantation.

Furthermore, the step S400 comprises steps S410-S420.

The step S410 comprises forming the N-base region 260 at the upper end of the P-base region 230 and between each two adjacent N-pillars 210 by performing an N-type ion implantation, forming the N + regions disposed in the second direction at the upper end of the P-base region 230 and between the two trenches 310 disposed above each of the N-pillars 210, and exposing upper surfaces of the N + regions.

The step S420 comprises forming the first P + layer 250 on the upper portion of the N-base region 260 by performing a P-type ion implantation, forming the P + regions 270 on portions of the upper portion of the P-base region 230 between adjacent N + regions, and exposing an upper surface of the first P + layer 250 and upper surfaces of the P + region.

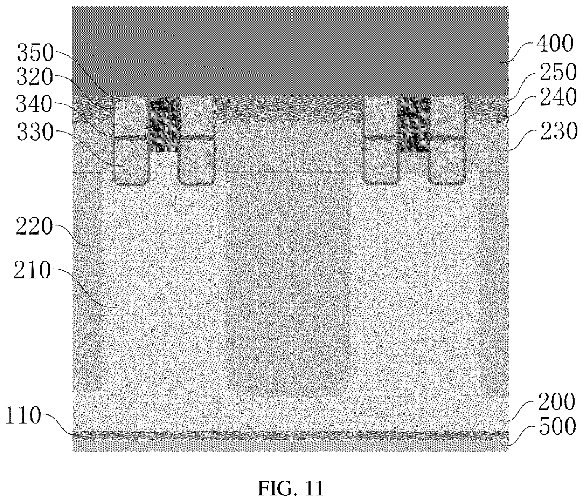

As shown in FIG. 11, the step S500 comprises forming separation gates 300 respectively in the trenches 310. The step S500 comprises steps S510-S530.

The step S510 comprises etching first polysilicon disposed in each of the trenches 310, and retaining a portion of the first polysilicon disposed at a lower portion of each of the trenches 310 to form a gate electrode.

The step S520 comprises depositing an oxide layer on an upper end of each gate electrode to form a gate dielectric layer.

The step S530 comprises growing second polysilicon on an upper portion of each of the trenches 310, and etching to form a cathode.

As shown in FIG. 11, the step S600 comprises forming an emitter metal at an upper end of the epitaxial layer 200; forming a second P + layer 110 by performing the ion implantation on the N-type doped silicon substrate; and forming a back metal 500 at a lower end of the second P + layer 110.

Since the upper surfaces of the N+ regions 260, upper surfaces of the first P+ layer 250, the upper surfaces of the P+ regions 270, and the cathode 350 are all exposed, the emitter is formed by a self-aligned contact hole process, thereby omitting the dielectric layer and the tungsten plugs, and making the process window large. The preparation methods making the super-junction IGBT device (when conventional SJ-IGBT devices are of a small size, related preparation process of active region contact holes connected to the P-base region leads to a narrow process window) have a smaller pitch size (a minimum repeating unit size, i.e., a size of one N-pillar 210 and one P-pillar 220). Of course, the manufacturers are also allowed to grow the dielectric layer on the super-junction IGBT device, etch contact holes on the dielectric layer, and form the tungsten plugs in the contact holes, so that the emitter metal 400 is connected to the N+ region s260, the first P+ layer 250, the P+ regions 270 and the cathode 350 through the tungsten plugs.

The super-junction IGBT device manufactured by the preparation method of the embodiment reduces the on-state voltage drop and the turn-off loss, and further reduces the Miller capacitance and the switch loss. In addition, the dielectric layer and the tungsten plugs are omitted, and the process window is increased, which enables the super-junction IGBT device to have a small size.

## Claims

1. A super-junction insulated gate bipolar transistor (IGBT) device with separation gate structures, comprising:
an epitaxial layer (200);
P-pillars (220) and N-pillars (210) periodically formed in the epitaxial layer (200) by performing ion implantation;
a P-base region (230) formed on an upper portion of the epitaxial layer (200) by performing the ion implantation;
the separation gate structures disposed above the N-pillars;
an N-base region (240) formed between the separation gate structures and formed on the P-base region (230) by performing the ion implantation
a first P + layer (250) formed on the N-base region (240) by performing the ion implantation;
a second P + layer (110) disposed on a lower end of the epitaxial layer (200);
a back metal (500) disposed at a lower end of the second P + layer (110); and
an emitter metal (400) disposed at upper ends of the separation gate structures and an upper end of the first P + layer (250);
wherein the P-pillars (220) and the N-pillars (210) are periodically disposed below the P-base region (230) along a first direction, an upper end of each of the P-pillars (220) and an upper end of each of the N-pillars (210) are connected to the P-base region (230), and a doping concentration of the P-base region (230) is greater than a doping concentration of the P-pillars (220).

2. The super-junction IGBT device with the separation gate structures of claim 1, wherein each of the separation gate structures comprises two trenches (310), separation gates (300), N + regions (260) and P + regions (270);
wherein the separation gates (300) are respectively disposed in the two trenches (310), the N + regions (260) and the P + regions (270) are periodically disposed between the two trenches (310) along a second direction, and the second direction is perpendicular to the first direction.

3. The super-junction IGBT device with the separation gate structures of claim 2, wherein each of the separation gates (300) comprises a gate oxide layer (320) covering a trench wall of a corresponding one of the trenches (310), a gate electrode (330) disposed at a lower portion of the corresponding one of the trenches (310), a cathode (350) disposed at an upper portion of the corresponding one of the trenches (310), and a gate dielectric layer (340) disposed between the gate electrode (330) and the cathode (350).

4. The super-junction IGBT device with the separation gate structures of claim 3, wherein a depth of each of the P + regions (270) is the same as a depth of the first P + layer (250).

5. The super-junction IGBT device with the separation gate structures of claim 4, wherein a lower end surface of each of the N+ regions (260) is lower than an upper end surface of each gate electrode (330).

6. The super-junction IGBT device with the separation gate structures of claim 3, wherein an upper end of the first P + layer (250), an upper end of each of the P + regions (270), an upper end of each of the N+ regions (260), and an upper end of each cathode (350) are directly connected to the emitter metal (400).

7. A preparation method of a super-junction IGBT device with separation gate structures, comprising steps:
S100: providing an N-type doped silicon substrate (100);
S200: epitaxially growing N-type doped silicon on the N-type doped silicon substrate (100) to form an epitaxial layer (200), and forming P-pillars (220) disposed along a first direction by performing ion implantation on the epitaxial layer (200), wherein portions of the epitaxial layer (200) disposed between the P-pillars (220) are defined as N-pillars (210);
S300: performing the ion implantation on an upper portion of the epitaxial layer (200) to form a P-base region (230), and forming two trenches (310) above each of the N-pillars (210); wherein the two trenches (310) extend downward to penetrate through the P-base region (230) and extend into each of the N-pillars (210);
S400: forming N + regions (260) and P + regions (270) periodically disposed in a second direction at an upper end of the P-base region (230) and between the two trenches (310) disposed above each of the N-pillars (210) by performing the ion implantation, and forming a N-base region (240) and a first P + layer (250) at the upper end of the P-base region (230) and between each two adjacent N-pillars (210) by performing the ion implantation;
S500: forming separation gates (300) respectively in the trenches (310); and
S600: forming an emitter metal (400) at an upper end of the epitaxial layer (200), forming a second P + layer (110) by performing the ion implantation on the N-type doped silicon substrate (100), and forming a back metal (500) at a lower end of the second P + layer (110).

8. The preparation method of claim 7, wherein in the step S200, the epitaxial layer (200) is formed by epitaxially growing a plurality of N-type doped silicon layers, and the ion implantation is performed at positions of each of the N-type doped silicon layers to form P-pillar segments (221).

9. The preparation method of claim 7, wherein the step S400 comprises steps:
S410: forming the N-base region (240) at the upper end of the P-base region (230) and between each two adjacent N-pillars (210) by performing an N-type ion implantation, forming the N + regions (260) disposed in the second direction at the upper end of the P-base region (230) and between the two trenches (310) disposed above each of the N-pillars (210), and exposing upper surfaces of the N + regions (260); and
S420: forming the first P + layer (250) on the upper portion of the N-base region (240) by performing a P-type ion implantation, forming the P + regions (270) on portions of the upper portion of the P-base region (230) between adjacent N + regions (260), and exposing an upper surface of the first P + layer (250) and upper surfaces of the P + region (270).

10. The preparation method of claim 7, wherein the step S500 comprises steps:
S510: etching first polysilicon (331) disposed in each of the trenches (310), and retaining a portion of the first polysilicon (331) disposed at a lower portion of each of the trenches (310) to form a gate electrode (330);
S520: depositing an oxide layer on an upper end of each gate electrode (330) to form a gate dielectric layer (340); and
S530: growing second polysilicon on an upper portion of each of the trenches (310), and etching to form a cathode (350).

## Amended claims

### Amended claims in accordance with Rule 137(2) EPC.

1. A super-junction insulated gate bipolar transistor (IGBT) device with split gate structures, comprising:
an epitaxial layer (200);
P-pillars (220) and N-pillars (210) periodically formed in the epitaxial layer (200);
a P-base region (230) formed on an upper portion of the epitaxial layer (200);the split gate structures disposed above the N-pillars (210);
an N-type region (240) formed between the split gate structures and formed on the P-base region (230);
a first P + layer (250) formed on the N-type region (240);
a second P + layer (110) disposed on a lower end of the epitaxial layer (200);
a back metal (500) disposed at a lower end of the second P + layer (110); and
an emitter metal (400) disposed at upper ends of the split gate structures and an upper end of the first P + layer (250);
wherein the P-pillars (220) and the N-pillars (210) are periodically disposed below the P-base region (230) along a first direction, an upper end of each of the P-pillars (220) and an upper end of each of the N-pillars (210) are connected to the P-base region (230), and a doping concentration of the P-base region (230) is greater than a doping concentration of the P-pillars (220);
wherein each of the slit-gate structures comprises two trenches (310), split gates (300), N + regions (260) and P + regions (270); wherein the split gates (300) are respectively disposed in the two trenches (310), wherein the N + regions (260) and the P + regions (270) are periodically disposed between the two trenches (310) along a second direction, and the second direction is perpendicular to the first direction; wherein each of the split gates (300) comprises a gate oxide layer (320) covering a trench wall of a corresponding one of the trenches (310), a gate electrode (330) disposed at a lower portion of the corresponding one of the trenches (310), a cathode (350) disposed at an upper portion of the corresponding one of the trenches (310), and a gate dielectric layer (340) disposed between the gate electrode (330) and the cathode (350);
wherein an upper end of the first P + layer (250), an upper end of each of the P + regions (270), an upper end of each of the N+ regions (260), and an upper end of each cathode (350) are directly connected to the emitter metal (400).

2. The super-junction IGBT device with the split gate structures of claim 1, wherein a depth of each of the P + regions (270) is the same as a depth of the first P + layer (250).

3. The super-junction IGBT device with the split gate structures of claim 2, wherein a lower end surface of each of the N+ regions (260) is lower than an upper end surface of each gate electrode (330).

4. The super-junction IGBT device with the split gate structures of claim 1,.

5. A preparation method of a super-junction IGBT device with split gate structures, comprising steps:
S100: providing an N-type doped silicon substrate (100);
S200: epitaxially growing N-type doped silicon on the N-type doped silicon substrate (100) to form an epitaxial layer (200), and forming P-pillars (220) disposed along a first direction by performing ion implantation on the epitaxial layer (200), wherein portions of the epitaxial layer (200) disposed between the P-pillars (220) are defined as N-pillars (210);
S300: performing the ion implantation on an upper portion of the epitaxial layer (200) to form a P-base region (230), and forming two trenches (310) above each of the N-pillars (210); wherein the two trenches (310) extend downward to penetrate through the P-base region (230) and extend into each of the N-pillars (210);
S400: forming N + regions (260) and P + regions (270) periodically disposed in a second direction at an upper end of the P-base region (230) and between the two trenches (310) disposed above each of the N-pillars (210) by performing the ion implantation, and forming a N-type region(240) and a first P + layer (250) at the upper end of the P-base region (230) and between each two adjacent N-pillars (210) by performing the ion implantation;
S500: forming split gates (300) respectively in the trenches (310) , wherein each split gate (300) comprises a gate oxide layer (320) covering a trench wall of a corresponding one of the trenches (310), a gate electrode (330) disposed at a lower portion of the corresponding one of the trenches (310), a cathode (350) disposed at an upper portion of the corresponding one of the trenches (310), and a gate dielectric layer (340) disposed between the gate electrode (330) and the cathode (350); and
S600: forming an emitter metal (400) at an upper end of the epitaxial layer (200), such that an upper end of the first P+ layer (250), an upper end of each of the P+ regions (270), an upper end of each of the N+ regions (260), and an upper end of each cathode (350) are directly connected to the emitter metal (400), forming a second P + layer (110) by performing the ion implantation on the N-type doped silicon substrate (100), and forming a back metal (500) at a lower end of the second P + layer (110).

6. The preparation method of claim 5, wherein in the step S200, the epitaxial layer (200) is formed by epitaxially growing a plurality of N-type doped silicon layers, and the ion implantation is performed at positions of each of the N-type doped silicon layers to form P-pillar segments (221).

7. The preparation method of claim 5, wherein the step S400 comprises steps:
S410: forming the N-type region(240) at the upper end of the P-base region (230) and between each two adjacent N-pillars (210) by performing an N-type ion implantation, forming the N + regions (260) disposed in the second direction at the upper end of the P-base region (230) and between the two trenches (310) disposed above each of the N-pillars (210), and exposing upper surfaces of the N + regions (260); and
S420: forming the first P + layer (250) on the upper portion of the N-type region(240) by performing a P-type ion implantation, forming the P + regions (270) on portions of the upper portion of the P-base region (230) between adjacent N + regions (260), and exposing an upper surface of the first P + layer (250) and upper surfaces of the P + region (270).

8. The preparation method of claim 5, wherein the step S500 comprises steps:
S510: etching first polysilicon (331) disposed in each of the trenches (310), and retaining a portion of the first polysilicon (331) disposed at a lower portion of each of the trenches (310) to form a gate electrode (330);
S520: depositing an oxide layer on an upper end of each gate electrode (330) to form a gate dielectric layer (340); and
S530: growing second polysilicon on an upper portion of each of the trenches (310), and etching to form a cathode (350).
